# EUROPEAN PATENT APPLICATION

(11) **EP 2 811 509 A1**
(43) Date of publication of application: **10.12.2014**
(21) Application number: 13171156.6
(22) Date of filing: 07.06.2013
(51) Int. Cl.: H01J 37/34, C23C 14/35

(54) **Electronic configuration for magnetron sputter deposition systems**

(71) Applicant: Soleras Advanced Coatings bvba, 9800 Deinze (BE)
(72) Inventor: De Bosscher, Wilmert, 9031 Drongen (BE)
(74) Representative: Wauters, Davy Erik Angelo

(57) **Abstract**

A magnetron sputter deposition system (100) for sputtering material is described. The system comprises at least two magnetron sputter units (102, 104), a power supply (110) for providing a power, the power supply (110) comprising an electrode wherein the at least two magnetron sputter units (102, 104) are simultaneously electrically connected to the same electrode of the power supply (110), and the magnetron sputter units are arranged so that they at least partly share a common plasma in the region between the at least two magnetron sputter units (102, 104).

## Description

### Field of the invention

The invention relates to the field of sputter deposition devices. More specifically it relates to a multiple magnetron sputter deposition system and the electronic circuit configuration thereof.

### Background of the invention

Sputter deposition has become a widespread technique to add functionalities to substrates such as film, sheet form materials or more complex shaped 3-dimensional objects. In a low-pressure sputter deposition coater, ionized gas ions are accelerated towards a negatively biased target. Atoms are kicked out of the target when the gas ions impinge on its surface. A magnet system may be provided under the target surface to confine the free electrons in a racetrack. Within the racetrack the ionization degree of the gas is greatly increased and the ion bombardment of the target is therefore more intense below the racetrack. Hence the magnet system defines the area on the target from which atoms are sputtered away. Moreover, under the racetrack, target atoms are ejected mainly in a direction according to a Lambertian distribution perpendicular to the surface of the target. Such a process is known as magnetron sputter deposition. The knocked-out atoms hit the substrate surface where a dense coating forms. When also reactive gasses are admitted into the coater, reactions with the impinging target atoms will occur at the surface of the substrate, enabling the formation of compound materials such e.g. as oxides or nitrides.

In order to increase yield, to increase use of sputter material or to increase sputtering rates, etc. sputtering coaters have been developed wherein a single sputter system comprises a plurality of magnetron sputter units. Sputtering systems with multiple magnetron sputter units may be operated in DC or in AC or pulsed DC or RF mode. While DC power supplies are very effective, the corresponding sputtering process seems more difficult to control in the case of reactive processes forming compound layers. The use of RF, AC or pulsed DC sources enables better control of the sputter deposition, but the output is lower for the same primary input power of the DC power supply.

When DC powering is used, in existing systems typically each magnetron unit is powered by a separate DC power supply to obtain high output. It is generally accepted that, although theoretically multiple magnetron sputter units may have the same electrical characteristics, in practice, no two magnetron systems have the same impedance, due to differences in fabrication processes, microstructure, internal geometry, etc, of magnetic system and used target material and therefore it is not as such possible to use a single same power source for different magnetrons. If the magnetrons would exactly be equipotential, the output power for each would be different since each magnetron may carry a different current density, this typically will result in an unequal sputtering process. Due to propagation, inherently this will lead to one sputter target taking over the sputtering process while the sputtering process at the other target(s) is suppressed.

US6509656 describes a system and method for powering two magnetron devices using a single power supply. The system includes a control device for controlling an amount of current reaching at least the first magnetron device. Current control can for example be performed using Hall-effect current transformers. Nevertheless, such current control typically may be complex.

### Summary of the invention

It is an object of embodiments of the present invention to provide a method and device to obtain an effective and controllable sputtering on a magnetron sputter system comprising a plurality of magnetron units, without the previous problems and commercially disadvantageous solutions.

The above objective is accomplished by a method and device according to the present invention.

The present invention relates to a magnetron sputter deposition system for sputtering material or for performing a plasma treatment, the magnetron sputter deposition system comprising at least two magnetron sputter units, each magnetron sputter unit comprising a magnet configuration and a mounting surface for mounting a target, a power supply for providing a power, the power supply comprising an electrode wherein the at least two magnetron sputter units are simultaneously electrically connected to the same electrode of the power supply, and the magnetron sputter units are arranged so that they at least partly share a common plasma in the region between the at least two magnetron sputter units during sputtering. It is to be noticed that with at least partly sharing a common plasma there is meant that at least a fraction of the plasma is to be shared between the at least two magnetron sputter units, but that part of the plasma also may be local to a local racetrack at a specific magnetron sputter unit. Such a fraction may e.g. be at least 10% of the plasma, e.g. at least 30% of the plasma, e.g. at least 50% of the plasma.

The power source may be a DC power supply comprising at least a negative electrode and the at least two magnetron sputter units may be simultaneously electrically connected to the same negative electrode of the power supply.

Alternatively, the power supply may be a switching power supply being any of a pulsed DC, AC or RF power supply and the at least two magnetron sputter units may be simultaneously electrically connected to a same electrode of the switching power supply.

It is an advantage of some of the embodiments of the present invention that a common power supply can be used, without one of the magnetron sputter units resulting in non-optimal, bad or even no sputtering activity during the sputtering process. The latter is obtained because electron current between targets mounted on the two magnetron sputter units can be obtained, resulting in a self regulating electrical behaviour of the magnetron sputter units. More particularly, although a common power is used, it still can be avoided that there is malfunctioning of one of the magnetron sputter units over time. The latter is particularly advantageous, e.g. when DC powering is used, although not limited thereto.

It is an advantage of embodiments of the present invention that a sputtering deposition system can be provided that requires less components, i.e. a single power source for all magnetron sputter units instead of a separate power source for each magnetron sputter unit. Limiting the number of components results in a less complex system which is faster in production, lower in price, more resistant to failure, requires less time for maintenance, etc.

The magnet configurations of the at least two magnetron sputter units may be opposite magnet configurations so as to generate shared magnetic field lines between the magnet configurations of the at least two magnetron sputter units. It is an advantage of embodiments of the present invention that sharing a common plasma in the region between the at least two magnetron sputter units can be obtained by properly selecting the magnet configurations in the different magnetron sputter units.

The magnet configurations of the at least two magnetron sputter units may be arranged so that a substantial fraction, e.g. at least 10% or e.g. at least 30% or e.g. at least 50%, of the magnetic field lines of at least one of the arrays are shared with at least one array of another magnet configuration. It is an advantage of embodiments of the present invention that the current between the different magnetron sputter units can be appropriately balanced between different magnetron sputter units, even if the sputtering process and/or sputtering conditions is different for the different magnetron sputter units.

The shortest distance between target surfaces of different targets when supported by the magnetron sputter units may be smaller than 150mm, e.g. smaller than 100mm or smaller than 50mm.

The magnetron sputter units may be adapted for supporting tubular targets. It is an advantage of embodiments of the present invention that tubular targets can be used, typically resulting in a better use of sputter target material than when flat targets are used.

The tubular targets may have a rotational axis and the distance between rotational axis of different tubular targets when supported by the magnetron sputter units may be smaller than 300 mm, e.g. smaller than 250mm. It is an advantage of embodiments of the present invention that the current between the different magnetron sputter units can be appropriately balanced between different magnetron sputter units even if the sputtering process and/or sputtering conditions are different for the different magnetron sputter units.

The sputter deposition system may comprise a separate conducting anode unit. Such a separate conducting anode unit may in some embodiments be the gas inlet for supplying the sputter gas. In other words, the sputter deposition system furthermore may comprise a gas inlet for supplying sputter gas, wherein the gas inlet is connected to the anode of the DC power source. It is an advantage of embodiments of the present invention that in this way all electrons have a controlled path, as the electrons can use the separate conducting anode unit as electron conduction path once they leave the racetrack. In some embodiments, when the gas inlet is configured as a conducting anode, the gas inlet may further be arranged electrically and mechanically so that a plasma plume is induced by the gas inlet which can act as a virtual anode during sputtering.

It is an advantage of embodiments of the present invention that the gas inlet may be electrically connected to a positive electrode of the DC power source, allowing that the sputter gas to ionize and to behave as a virtual anode. It is an advantage of embodiments of the present invention that the presence of a virtual anode may overcome the problem of a the disappearing anode commonly occurring in DC reactive sputtering because dielectric material is sputtered onto the anode, as in the present case the anode is virtual and not a mechanical component.

The present invention also relates to a vacuum apparatus for plasma coating or plasma treatment of a surface, the vacuum apparatus comprising a vacuum chamber, a substrate holder for positioning a substrate and a magnetron sputter system as described above.

The present invention furthermore relates to a method for controlling a magnetron sputter system, the method comprising simultaneously powering at least two magnetron sputter units of the magnetron sputter system by connecting them to a same electrode of a power supply, wherein the at least two magnetron sputter units are arranged so that they at least partly share a common plasma in the region between the at least two magnetron sputter units during sputtering, ,maintaining a plasma at least partly shared between the at least two magnetron sputter units and sputtering material for coating or treatment of the substrate surface.

Said simultaneously powering may be simultaneously powering the at least two magnetron sputter units of the magnetron sputter system by connecting them to the same negative electrode of a DC power supply.

Said simultaneously powering may be simultaneously powering the at least two magnetron sputter units of the magnetron sputter system by connecting them to a same electrode of a switching power supply being any of a pulsed DC, AC or RF power supply.

The method may comprise supplying a sputter gas in the system through a gas inlet. The method furthermore may comprise connecting the at least one gas inlet to a positive electrode of a DC power supply for inducing a controlled path to the anode during sputtering.

Particular and preferred aspects of the invention are set out in the accompanying independent and dependent claims. Features from the dependent claims may be combined with features of the independent claims and with features of other dependent claims as appropriate and not merely as explicitly set out in the claims. These and other aspects of the invention will be apparent from and elucidated with reference to the embodiment(s) described hereinafter.

### Brief description of the drawings

FIG. 1 illustrates different opposed magnet configurations that can be used in magnetron sputter deposition systems according to embodiments of the present invention.
FIG. 2 illustrates a configuration of an exemplary magnetron sputter deposition system according to embodiments of the present invention.
FIG. 3 illustrates a configuration of a particular example of a magnetron sputter deposition system using a DC power source, according to an embodiment of the present invention.
FIG. 4 and FIG. 5 illustrate a configuration of a particular example of a magnetron sputter deposition system using a DC power source and having a gas inlet configured as anode, according to an embodiment of the present invention, wherein FIG. 4 illustrates a configuration adapted for supporting tubular targets and FIG. 5 illustrates a configuration adapted for supporting planar targets.
FIG. 6 illustrates a configuration of a particular example of a magnetron sputter deposition system adapted for using a switched power supply, according to an embodiment of the present invention.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Where in embodiments of the present invention reference is made to a power supply, reference may be made to a DC power supply as well as to a switched power supply such as for example a pulsed DC power supply, an AC power supply or an RF power supply.

Where in embodiments of the present invention reference is made to a DC power supply, it will be clear to the skilled person that reference is made to a power supply operating in DC mode.

Where in embodiments of the present invention reference is made to "negative electrode", reference is made to the reference potential, or negative output, of the power source. Where in embodiments of the present invention reference is made to "positive electrode", reference is made to the positive output, of the power source. Said positive electrode may be ground in certain embodiments comprising a power source connected to ground reference potential.

Where in embodiments of the present invention reference is made to a magnetron sputter deposition system, reference is made to an assembly of at least two magnetron sputter units each suitable for supporting a target from which material can be sputtered. The magnetron sputter deposition system optionally also may comprise other components.

Where in embodiments of the present invention reference is made to a magnetron sputter unit reference is made to a combination of a magnet configuration and a target holder with a mounting surface for mounting a single target. Optionally also other components also can be included as will be described further.

Where in embodiments of the present invention reference is made to "sputter gas", reference is made to gas or gas mixtures used during the sputtering process. Typically, during sputtering the sputter gas is partially ionized and thus becomes in a plasma state. The most common sputter gas which is used is argon, which is commonly ionized to Ar⁺, although embodiments of the present invention are not limited to the use of argon and other sputter gasses also could be used.

Where in embodiments of the present invention reference is made to a virtual anode, reference is made to the situation wherein a plasma plume acts as an anode and thus acting as a conductive path for electrons. Use is made of the word "virtual" as it does not refer to a fixed mechanical element such as a piece of metal, but it refers to a plasma, like a cloud of ions, which is not fixed, but continuously changes/renews. An advantage thereof is that e.g. deposition of materials on the virtual anode is not really possible and therefore poisoning of such an anode is also is avoided.

In a first aspect, embodiments of the present invention relate to a magnetron sputter deposition system suitable for depositing a coating or layer on an object such as for example a substrate. The substrate to be coated may be a conventional plate like substrate, may be a sheet-like material, may be one or more 3-dimensional objects, etc. The sputtering method typically is a physical vapour deposition (PVD) process. It is to be noticed that embodiments of the present invention is not limited by the type of substrates, targets or gasses that may be used.

According to embodiments of the present invention, reference is made to systems for sputtering. The sputtering processes involved may be conventional sputtering processes, reactive sputtering processes, etc. embodiments of the present invention not being limited thereto. It is to be noticed that the sputtering device and process according to embodiments of the present invention are related to magnetron sputtering, the latter being indicative of the fact that a magnet configuration is used to confine the plasma near the sputtering target.

According to embodiments of the present invention, the magnetron sputter deposition system comprises two or more magnetron sputter units. In a number of embodiments, exactly two magnetron sputter units will be used. Nevertheless, systems with three, four or more magnetron sputter units also may be present. Each magnetron sputter unit typically comprises a magnet configuration and a target holder comprising a mounting surface for mounting a sputter target. The magnet configuration may comprise a single magnet, a magnet array, a double magnet, a double magnet array, three magnets, a triple magnet array, etc. The number and type of magnets used may typically depend on the sputter target that is to be sputtered. In case tubular targets, the magnets used typically will be inserted inside the tubular targets, and in view of the typical lengths of tubular targets, typically a triple magnet array is often selected. When the target holder is adapted for carrying a planar target, typically a magnet configuration is selected that results in a racetrack erosion of the target material. The magnet configuration typically may consist of permanent magnets, although inventions are not limited thereto. The target holder of each magnet configuration may, in some embodiments, be adapted for supporting tubular targets, for supporting flat or planar targets, etc.

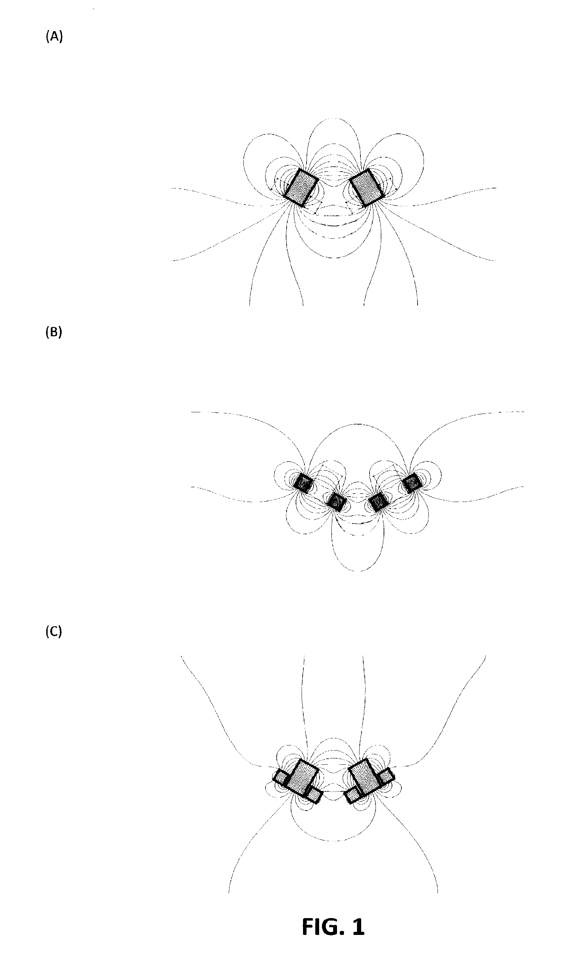

According to embodiments of the present invention, the magnetron sputter units are arranged so that the magnetron sputter units can at least partly share a common plasma in a plasma region between neighbouring targets when these are positioned in the magnetron sputter units. In one embodiment, the possibility of at least partly sharing a plasma is established by selecting magnetron configurations in neighbouring magnetron sputter units that have opposite configuration. A plurality of magnet configuration can be used for such opposed configurations. A number of such configurations, illustrating the principle, are shown schematically in FIG. 1 whereby some magnetic field lines are indicated, part of them being common magnetic field lines between neighbouring magnet configurations. The drawings in FIG. 1 illustrate simulation results for different magnetic configurations in a plane perpendicular to a length direction of the magnetic system, the different simulation results corresponding with simulations for magnetic configurations wherein only the magnets indicated with a thick line are present. In FIG. 1 (A), two neighbouring magnet configurations are shown, whereby a single magnet or magnet array is illustrated for each neighbouring magnet configuration. The neighbouring magnet configurations thereby have an opposed magnetic polarity, resulting in magnetic field lines not only closing within magnet configurations themselves but also in magnetic field lines shared between neighbouring magnet configurations. A similar situation can be seen in FIG. 1 (B) where for each magnet configuration a dual magnet or dual magnet array is provided, and whereby again some magnetic field lines close within the same magnet configuration and some magnetic field lines are shared between neighbouring magnet configurations. FIG. 1 (C) illustrates the corresponding situation for three magnets or three magnet arrays, showing the same features of magnetic field lines closing within the same magnet configuration and magnetic field lines being shared between neighbouring magnet configurations.

According to embodiments of the present invention, the magnetic configurations are arranged so that magnetic field lines are shared between neighbouring magnetron units of the at least two magnetron sputter units. In particular embodiments, the magnet configurations of the at least two magnetron sputter units may be arranged so that a substantial fraction, e.g. at least 10% or e.g. at least 30% or e.g. at least 50%, of the magnetic field lines of at least one of the arrays are shared with at least one array of another magnet configuration. This is illustrated in FIG. 1, two examples thereof being the shared lines between the different magnet arrays of different magnet configurations in FIG. 1 (A) and the shared magnetic field lines between the central magnet arrays of the different magnet configurations in FIG. 1(C).

According to embodiments of the present invention, the magnetic configurations may be arranged so that the shortest distance between neighbouring targets, when mounted on the target support of neighbouring magnetron sputter units, is smaller than 150mm, advantageously smaller than 100mm and in some embodiments even smaller than 50 mm. In particular embodiments, wherein the magnetron sputter units are adapted for using tubular targets having a rotational axis, the distance between rotational axis of neighbouring tubular targets may be smaller than 300mm, e.g. smaller than 250mm.

It further is to be noticed that the magnetron sputter units are arranged so that the sputter surface of (all) the targets, when mounted, can be directly seen by the substrate to be sputtered.

According to embodiments of the present invention, the magnetron sputter units are further adapted for electrically connecting the mounted targets as a cathode. More particularly, the at least two magnetron sputter units are electrically connected simultaneously to a same electrode of a power supply.

The system thus may comprise a single power supply for powering all magnetron sputter units. The power supply may be any suitable power supply typically used in magnetron sputter systems, such as for example a DC power supply, a pulsed DC power supply, a low or mid frequent AC power supply with symmetric or asymmetric wave shapes being more sine wave like or more square wave like or a radio frequent power supply..... In one particular embodiment the power supply is a DC power supply, which may ensure a high output and wherein the configuration of the cathodes and plasma enables great control of the sputtering.

The magnetron sputter units and/or the magnetron sputter deposition system may furthermore comprise further components such as for example cooling means and/or heating means, rotation means if e.g. rotatable targets are used, a gas inlet, ... It is to be noticed that the term gas inlet will be used regardless of the type of gas or gas mixture introduced in the sputter system. The one or more gas inlets may be a gas manifold. One or more of these components may be implemented in one or more end blocks.

One example of a component that typically is part of the magnetron sputter deposition system in a DC configuration may be one or more separate anode units. Such units may typically be insulated from the vacuum chamber and may extend over the complete length of the magnetron units or targets. It may be connected to the positive electrode of the DC power supply. The anode units may for example be advantageously be used for providing a conductive path for electrons that leave the plasma.

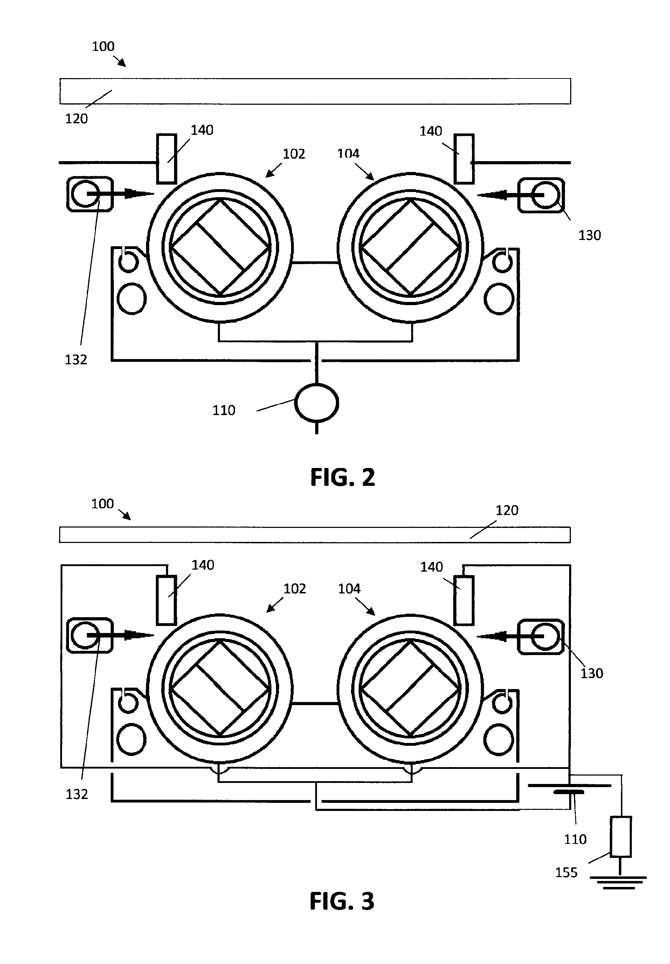

By way of illustration, embodiments of the present invention not being limited thereto, FIG. 2 illustrates an exemplary embodiment according to the present invention, wherein standard and optional components are shown. In FIG. 2, an exemplary magnetron sputter deposition system 100 is shown, comprising at least two magnetron sputter units 102, 104 each comprising a magnet configuration and a target holder with mounting surface for mounting a target. As will be clear, although in the exemplary system a target holder for tubular targets is shown, embodiments of the present invention are not limited thereto and also other target holders such a target holders suitable for holding planar targets are envisaged. Furthermore, the system 100 comprises a power supply 110, which may be a DC power supply, a pulsed DC power supply, an AC power supply, an RF power supply, etc. The two magnetron sputter units are simultaneously electrically connected to the same electrode of the power supply. The system also may comprise one or more gas inlets 130, 132 which may allow introducing sputter gas and/or reactive gas. The system 100 furthermore may comprise separate anodes 140 for collecting electrons once they have left the plasma.

In one of the embodiments, one or more gas inlets may be configured as anodes. The one or more gas inlets may therefore be electrically connected to a positive electrode of a DC power supply. In some embodiments, where a DC power supply is used for powering the magnetron sputter units, the one or more gas inlets also may be electrically connected to the positive electrode of this DC power supply. According to at least some embodiments of the present invention, the gas inlet that is configured for introducing the sputter gas thus may be connected to the anode of a DC power source.

In a further embodiment, the gas inlet thus may be arranged electrically and mechanically so that a plasma plume is induced by the gas inlet which can act as a virtual anode during sputtering. It thereby is an advantage that the presence of a virtual anode may overcome the problem of a the disappearing anode commonly occurring in DC reactive sputtering because dielectric material is sputtered onto the anode, as in the present case the anode is virtual and does not suffer from this effect. In this way an excess of electrons can be avoided, as the electrons can use the virtual anode and gas supply as electron conduction path.

By way of illustration, embodiments of the present invention not being limited thereto, some further examples of electrical configurations that can be applied in particular embodiments of the present invention are shown in FIG. 3 to FIG. 6.

FIG. 3 illustrates an electrical configuration for a magnetron sputter deposition system 100, wherein two magnetron sputter units 102, 104 are electrically connected to a negative electrode of a DC power supply 110 and wherein furthermore separate anodes 140, 142 are provided for providing an electron conductive path for electrons that leave the plasma. The anodes may be connected to ground via a resistor 155. The resistance value can be variable or fixed. In one setting, the variable or fixed resistance value may be 0 ohm, corresponding with the anode being connected to the ground. In another setting, the variable or fixed resistance value may correspond with an infinite value, corresponding with the anode being connected only to the positive pole of the power supply.

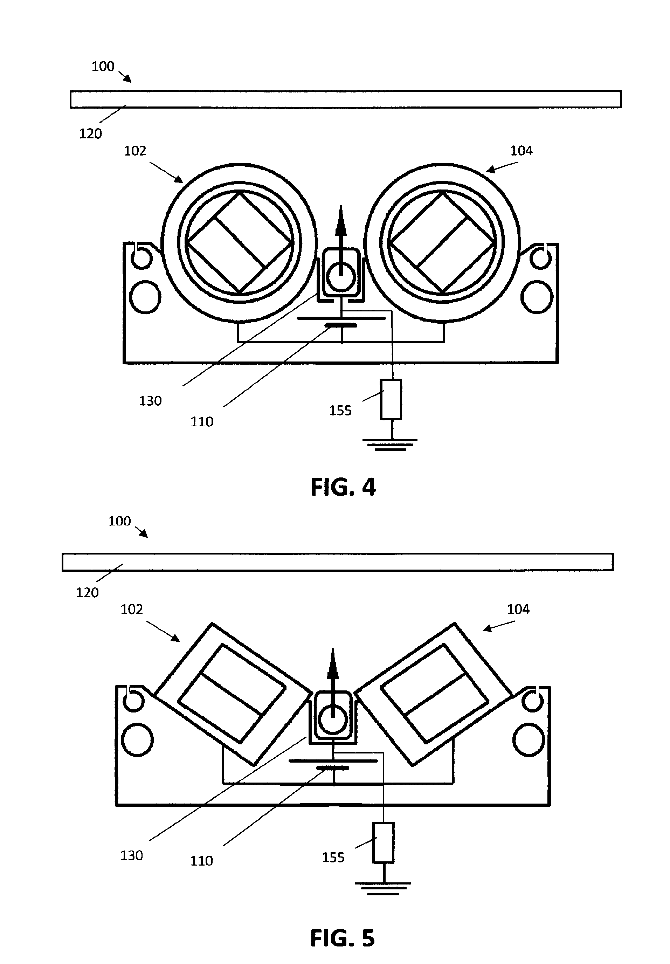

FIG. 4 illustrates an electrical configuration for a magnetron sputter deposition system 100, wherein two magnetron sputter units 102, 104 are electrically connected to a negative electrode of a DC power supply 110 and wherein a gas inlet 130 positioned between the two magnetron sputter units 102, 104 is electrically connected to a positive electrode of the DC power supply 110, the gas inlet thus acting as anode. The anodes may be connected to ground via a resistor 155. Whereas FIG. 4 illustrates the situation for tubular targets, FIG. 5 illustrates the same configuration for planar targets.

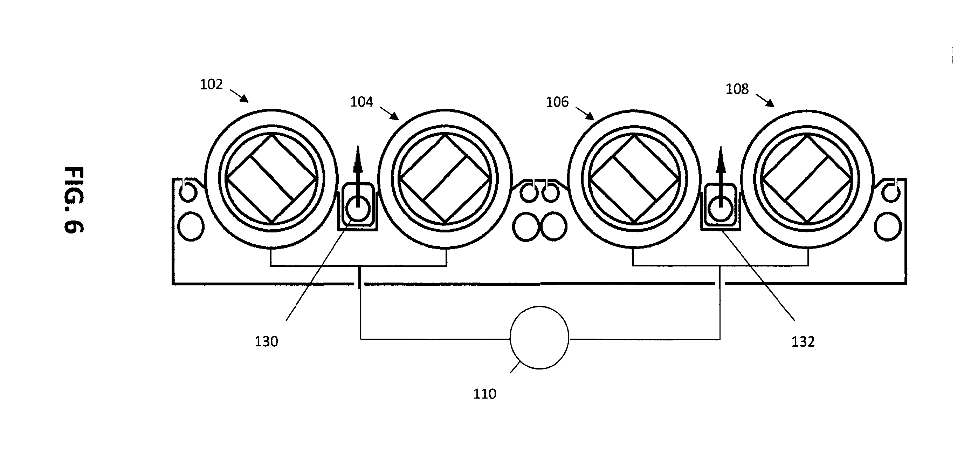

FIG. 6 illustrates a configuration wherein an AC power supply is used for providing a power to multiple magnetron sputter units. The magnetron sputter deposition system 100 comprises in the example shown four sputter magnetron units, wherein a first and a second sputter magnetron units 102, 104 are connected to one electrode of the AC power supply and a third and a fourth sputter magnetron units 106, 108 are connected to the other electrode of the AC power supply. The first and the second sputter magnetron unit at least partly share a plasma. Furthermore, also the third and fourth sputter magnetron unit at least partly share a plasma. By alternatively configuring the first and the second sputter magnetron units 102, 104 as cathodes and the third and the fourth sputter magnetron units 106, 108 as cathodes, alternatively these sets of sputter magnetron units are used for sputtering.

It is to be noticed that the examples shown are only shown by way of illustration, embodiments not being limited thereto, but only by the claimed subject matter.

In a second aspect, the present invention relates to a vacuum apparatus for plasma coating or plasma treatment of a surface. Such an apparatus typically may comprise a vacuum chamber, a substrate holder for positioning a substrate and a magnetron sputter system as described in embodiments of the first aspect. It is to be noticed that the apparatus typically also may comprise a number of other standard and optional components such as for example a vacuum pump, valves, windows, cooling elements, heating elements, transport systems, etc., these elements not being described in more details as these are not essential to the characterizing elements of the present invention and as these are known by the person skilled in the art.

In another aspect, the present invention provides a method for controlling a magnetron sputter system suitable for physical vapour deposition of a coating on a surface. According to embodiments of the present invention, the method thereby comprises simultaneously powering at least two magnetron sputter units of the magnetron sputter deposition system by connecting them simultaneously to the same electrode of a power supply. The magnetron sputter units thereby are arranged so that they share a common plasma in the region between the at least two magnetron sputter units during sputtering. By arranging the magnetron sputter units in this way, the magnetron units will advantageously become equipotential and additionally share electrons and current, thus avoiding efficiency reduction of one of the magnetron sputter units in favour of another magnetron sputter unit. The configuration of the magnetron sputter units may be called a shared-plasma configuration. It is to be noticed that according to embodiments of the present invention the sputtering surfaces of the targets when mounted on/supported by the magnetron sputter units, are directed with respect to a substrate when mounted in the substrate holder such that the substrate can be directly seen by the target surface. The powering may be DC powering or switched powering such as using a pulsed DC, an AC or an RF power source.

The method may additionally comprise supplying a sputter gas. The latter typically is performed using a gas inlet, which may be a gas supply device comprising one or more entry holes. The method furthermore comprises maintaining a common plasma shared between the at least two magnetron sputter units and sputtering material for coating the surface to be coated. The method may especially advantageously be performed using a system as described in the first aspect. It is an advantage of embodiments of the present invention that a highly efficient sputtering process can be obtained without the need for a large number of components in the sputtering device to be used. Furthermore, for controlling the sputtering process, it is sufficient that only a single power supply is controlled, and not a power supply for more or each of the magnetron sputter units. It is also an advantage of embodiments of the present invention that the cathodes are self-regulating, being kept equipotential at all times, and solving the current imbalance because of non-equal impedance of several magnetrons, hence providing the same sputter output yield and avoiding power supply limitation.

In a particular embodiment, the method furthermore comprises connecting the gas inlet to the positive electrode of the DC power supply. The latter may result in the possibility of generating a plasma plume from the sputter gas supplied, because the plasma gas becomes ionized when leaving the gas inlet. The gas inlet and the magnetron sputter units may then be arranged so that the plasma plume can act as a virtual anode, thus providing a conductive path for electrons that need to be removed from the common plasma between the sputter targets when sputtering is performed. It is an advantage of embodiments of the present invention that the anode of the system does not need to be maintenance continuously as it is a virtual anode and that nevertheless the contamination of the targets, which could lead to a reduced mode of operation, can be avoided or reduced.

It is to be noticed that these and other optional method steps may correspond with the functionality provided by standard and optional components of the magnetron sputter deposition system as described in the first aspect.

## Claims

1. A magnetron sputter deposition system (100) for sputtering material, the magnetron sputter deposition system (100) comprising:
- at least two magnetron sputter units (102, 104), each magnetron sputter unit (102, 104) comprising a magnet configuration and a mounting surface for mounting a target,
- a power supply (110) for providing a power, the power supply (100) comprising an electrode to be connected to the magnetron sputter units (102, 104)
wherein the at least two magnetron sputter units (102, 104) are simultaneously electrically connected to the same electrode of the power supply, and the magnetron sputter units (102, 104) are arranged so that they at least partly share a common plasma in the region between the at least two magnetron sputter units (102, 104) during sputtering.

2. A magnetron sputter deposition system (100) according to claim 1, wherein the power source (110) is a DC power supply comprising at least a negative electrode and wherein the at least two magnetron sputter units (102, 104) are simultaneously electrically connected to the same negative electrode of the power supply (110).

3. A magnetron sputter deposition system (100) according to claim 1, wherein the power supply (110) is a switching power supply being any of a pulsed DC, AC or RF power supply and wherein the at least two magnetron sputter units (102, 104) are simultaneously electrically connected to a same electrode of the switching power supply (110).

4. The magnetron sputter deposition system (100) according to any of the previous claims, wherein the magnet configurations of the at least two magnetron sputter units (102, 104) have opposite polarity so as to generate shared magnetic field lines between the magnet configurations of the at least two magnetron sputter units (102, 104).

5. The magnetron sputter deposition system (100) according to any of the previous claims, wherein the magnet configurations of the at least two magnetron sputter units (102, 104) are arranged so that at least 10%, advantageously at least 30% or e.g. at least 50%, of the magnetic field lines of at least one of the arrays are shared with at least one array of another magnet configuration.

6. The magnetron sputter deposition system (100) according to any of the previous claims, wherein the shortest distance between target surfaces of different targets when supported by the magnetron sputter units (102, 104) is smaller than 150mm, advantageously smaller than 100mm, more advantageously smaller than 50mm.

7. The magnetron sputter deposition system (100) according to any of the previous claims, wherein the magnetron sputter units (102, 104) are adapted for supporting tubular targets.

8. The magnetron sputter deposition system (100) according to any of the previous claims, wherein the tubular targets have a rotational axis and wherein the distance between rotational axis of different tubular targets when supported by the magnetron sputter units (102, 104) is smaller than 300 mm, e.g. smaller than 250mm or smaller than 200 mm.

9. The magnetron sputter deposition system (100) according to any of the previous claims, the magnetron sputter deposition system (100) furthermore comprising a gas inlet (130, 132) for supplying sputter gas, wherein the gas inlet is connected to an anode of a DC power source.

10. The magnetron sputter system (100) according to claim 9, wherein the gas inlet (130) is arranged electrically and mechanically so that a plasma plume is induced by the gas inlet which can act as a virtual anode during sputtering.

11. A vacuum apparatus for plasma coating or plasma treatment of a surface, the vacuum apparatus comprising a vacuum chamber, a substrate holder for positioning a substrate and a magnetron sputter deposition system (100) according to any of claims 1 to 10.

12. A method for controlling a magnetron sputter deposition system (100), the method comprising
- simultaneously powering at least two magnetron sputter units (102, 104) of the magnetron sputter system by connecting them to the same electrode of a power supply (110), wherein the at least two magnetron sputter units (102, 104) are arranged so that they at least partly share a common plasma in the region between the at least two magnetron sputter units during sputtering,
- maintaining a plasma at least partly shared between the at least two magnetron sputter units (102, 104) and sputtering material for coating or treatment of the surface.

13. A method for controlling a magnetron sputter deposition system (100) according to claim 12, wherein said simultaneously powering is simultaneously powering the at least two magnetron sputter units (102, 104) of the magnetron sputter deposition system (100) by connecting them to the same negative electrode of a DC power supply.

14. A method for controlling a magnetron sputter deposition system (100) according to claim 12, wherein said simultaneously powering is simultaneously powering the at least two magnetron sputter units (102, 104) of the magnetron sputter deposition system (100) by connecting them to a same electrode of a switching power supply (110) being any of a pulsed DC, AC or RF power supply.

15. A method according to claim 12, wherein the method furthermore comprises connecting the at least one gas inlet to a positive electrode of a DC power (110) supply for inducing a plasma plume that can act as virtual anode during sputtering.
